(19) Europäisches Patentamt
European Patent Office
Office européen des brevets

(11) **EP 3 364 153 B1**

(12) **EUROPEAN PATENT SPECIFICATION**

(45) Date of publication and mention of the grant of the patent:
**25.11.2020 Bulletin 2020/48**

(21) Application number: **16854770.1**

(22) Date of filing: **04.07.2016**

(51) Int Cl.:
**G01C 21/00** *(2006.01)*    **A01B 69/00** *(2006.01)*

(86) International application number:
**PCT/CN2016/088316**

(87) International publication number:
**WO 2017/063387 (20.04.2017 Gazette 2017/16)**

(54) **METHOD FOR UPDATING ALL ATTITUDE ANGLES OF AGRICULTURAL MACHINE ON THE BASIS OF NINE-AXIS MEMS SENSOR**

VERFAHREN ZUR AKTUALISIERUNG ALLER STELLUNGSWINKEL EINER LANDWIRTSCHAFTLICHEN MASCHINE AUF BASIS EINES NEUNACHSIGEN MEMS-SENSORS

PROCÉDÉ DE MISE À JOUR DE TOUS LES ANGLES D'ATTITUDE DE MACHINE AGRICOLE SUR LA BASE D'UN CAPTEUR MEMS À NEUF AXES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.10.2015 CN 201510664990**

(43) Date of publication of application:
**22.08.2018 Bulletin 2018/34**

(73) Proprietor: **Shanghai Huace Navigation Technology Ltd.**
**Shanghai 201702 (CN)**

(72) Inventors:
• **REN, Qiang**
  **Shanghai 201702 (CN)**
• **WANG, Jiejun**
  **Shanghai 201702 (CN)**
• **DAI, Wending**
  **Shanghai 201702 (CN)**
• **CAO, Guangjie**
  **Shanghai 201702 (CN)**
• **DONG, Guangyang**
  **Shanghai 201702 (CN)**
• **TU, Rui**
  **Shanghai 201702 (CN)**

(74) Representative: **Kayahan, Senem et al**
**Yalciner Patent and Consulting Ltd.**
**Tunus Cad. No: 85/3-4**
**Kavaklidere Cankaya**
**06680 Ankara (TR)**

(56) References cited:
CN-A- 101 782 391      CN-A- 102 589 537
CN-A- 103 557 866      CN-A- 105 203 098
US-A1- 2015 127 259

• LV , YINXIN: 'RESEARCH ON INTEGRATED ATTITUDE DETERMINATION SYSTEM BASED ON MEMS/GPS FOR MICROUAV' CHINA MASTER'S THESES FULL-TEXT DATABASE 15 February 2015, pages 11 - 13 , 26, 27, 35, 37, 38, 44, 59 AND 66, XP055523107

**Description**

**Technical field**

The invention relates to the measurement technology field, and particularly relates to a method of updating the all-attitude angle of the agricultural machine based on a nine-axis MEMS sensor.

**Background**

With the developments of MEMS (Micro-Electro-Mechanical-System) sensor technology, navigation technology, and control technology among others all support Chinese agriculture, which makes precision agriculture an increasingly popular trend. During machine assisted driving of agricultural machines, information regarding various aspects of the vehicle, including a pitch angle, a rolling angle and a course angle can provide important data inputs for a high precision integrated navigation and control algorithm.

Currently, the inertial navigation system includes PINS (Platform Inertial Navigation System) and SINS (Strapdown Inertial Navigation System). Compared to PINS, SINS uses IMU (Inertial Measuring Unit) sensors to establish a "mathematical platform" by calculation, so as to replace PINS. SINS is generally used in aircraft navigation control systems.. However, in the field of agricultural machine control, research and application of SINS are still at an early stage. Furthermore, aircraft navigation control systems are significantly different from agricultural machine control in terms of the application objects and environmental conditions. The method of SINS implemented in aircraft navigation control systems cannot apply in the agricultural machine control.

LV, YINXIN, "RESEARCH ON INTEGRATED ATTITUDE DETERMINATION SYSTEM BASED ON MEMS/GPS FOR MICROUAV", CHINA MASTER'S THESES FULL-TEXT DATABASE, 15 February 2015 (2015-02-15), pages 11-13, 26, 27, 35, 37, 38, 44, 59 and 66, XP055523107 discloses a method of updating an all-attitude angle of machine based on a nine-axis MEMS sensor.

**Summary of the invention**

In view of the above-mentioned defects in applying inertial navigation in the agricultural machine, the invention provides a method of updating the all-attitude angle of an agricultural machine based on a nine-axis MEMS sensor, with small error, high precision, and reliability.

To achieve the objectives, the embodiments of the invention adopt the following technical solutions.

According to the present invention, a method of updating an all-attitude angle of an agricultural machine based on a nine-axis MEMS sensor. The method of updating the all-attitude angle of an agricultural machine based on a nine-axis MEMS sensor includes the following steps:

establishing an error model of a gyroscope, an electronic compass calibration ellipse model and a seven-dimensional EKF filtering model, and setting a parameter vector corresponding to a vehicle motional attitude;

acquiring data including an acceleration and an angular velocity of a motion of vehicle, and a geomagnetic field intensity in real time by a nine-axis MEMS sensor;

calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity;

data-fusion processing the angle, the velocity, the position information and the course angle of the vehicle by the seven-dimensional EKF filtering model, and updating a motional attitude angle of the vehicle in real time;

wherein the nine-axis MEMS sensor is composed of a three-axis gyroscope, a three-axis accelerometer, and a three-axis geomagnetic sensor.

According to the present invention, the step of establishing an error model of a gyroscope, an electronic compass calibration ellipse model and a seven-dimensional EKF filtering model, and setting a parameter vector corresponding to a vehicle motional attitude is described in detail as below:

calculating the angular velocity of the gyroscope in the error model of the gyroscope via an error calculation formula of the gyroscope; wherein the error calculation formula of the gyroscope is: $\omega = \omega_{ib} + b_{\omega r} + b_{\omega g}$, wherein $\omega$ is an angular velocity output by the gyroscope, $\omega_{ib}$ is a real angular velocity of the gyroscope, $b_{wr}$ is a zero drift of the gyroscope, and $b_{wg}$ is a white noise output by the gyroscope;

eliminating a magnetic field interference by the electronic compass calibration ellipse model; wherein the electronic compass calibration ellipse model is:

$$\frac{(mx - Xoffset)^2}{Xsf^2} + \frac{(my - Yoffset)^2}{Ysf^2} = 1 \ ,$$

wherein *mx, my* are magnetic field intensities, *Xoffset* and *Yoffset* are hard magnetic interferences, and *Xsf* and *Ysf* are soft magnetic interferences;

updating the vehicle attitude by the seven-dimensional EKF filtering model, wherein, the seven-dimensional EKF filtering model uses an extended Kalman filter for a seven-dimensional state vector, and EKF includes a state equation and an observation equation:

$$x = f(x, \omega) + w1$$

$$y = h(x) + v1$$

wherein the state matrix is $x = [q \ b_{ar}]$, q is quaternion vectors q0, q1, q2, q3, and $b_{\omega r}$ is a zero drift of the XYZ three-axis gyroscope, wherein $\omega$ is the angular velocity output by the gyroscope, *w1* is a process noise matrix, *v1* is an observation noise matrix, y is an observation vector, $y = [a \ \psi_{mag}]^T$, wherein a is a three-axis acceleration value, $\psi_{mag}$ is a course angle calculated by the electronic compass,

$$f(x, \omega) = \begin{bmatrix} \frac{1}{2} \begin{bmatrix} -q_1 & -q_2 & -q_3 \\ q_0 & -q_3 & q_2 \\ q_3 & q_0 & -q_1 \\ -q_2 & q_1 & q_0 \end{bmatrix} \begin{bmatrix} \omega_x - b_{\omega x} \\ \omega_y - b_{\omega y} \\ \omega_z - b_{\omega z} \end{bmatrix} \\ 0^{3 \times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}(\frac{2(q_1 q_2 + q_0 q_3)}{q_0^2 + q_1^2 - q_2^2 - q_3^2}) \end{bmatrix}$$

According to one aspect of the present invention, the step of acquiring data including an acceleration and an angular velocity of a motion of vehicle, and a geomagnetic field intensity in real time by a nine-axis MEMS sensor is described in detail as below:

obtaining the angular velocity of the vehicle through the gyroscope, and compensating the zero drift of the gyroscope;
acquiring acceleration data of the vehicle by an acceleration sensor; and
acquiring the geomagnetic field intensity of the vehicle by the geomagnetic sensor.

According to one aspect of the present invention, the step of calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity is described in detail as below:

obtaining angle data by an integral calculation of the angular velocity by the error model of the gyroscope;
calculating the velocity by integrating the acceleration data, and the position information is calculated by further integrating the velocity; and
calculating the course angle of the vehicle from geomagnetic field intensity data which is compensated by a calibration parameter and corrected by an oblique angle, and both the calibration parameter and the oblique angle being calculated by the elliptical model.

According to one aspect of the present invention, the step of data-fusion processing the angle, the velocity, the position information and the course angle of the vehicle by the seven-dimensional EKF filtering model, and updating a motional attitude angle of the vehicle in real time is described in detail as below:

calculating attitude data of the vehicle by the seven-dimensional EKF filtering model, through a quaternion attitude updating algorithm, wherein, a calculation process of the EKF algorithm is as below:

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^T + Q$$

$$x_k(+) = x_k(-) + K_k | y_k - h(x_k(-)) |$$

$$P_k(+) = [I - K_k H_k] P_k(-)$$

$$H_k = \frac{\partial h}{\partial x} |_k$$

$$K_k = P_k(-) H_k [H_k P_k(-) H_k^T + R_k]$$

wherein $k$ is a sampling time point, $x_k$ is a system state estimation, (-) is a previous time point, (+) is a later time point, $\Phi_k$ is a state transition matrix, $P_k$ is a minimum mean square error matrix, $Q$ is a covariance matrix corresponding to the state vector, $K_k$ is an error gain, $y_k$ is an observation vector, $H_k$ is a transition matrix for the observation equation, $R_k$ is a covariance matrix corresponding to the observation vector;

$$Q = \frac{q_0 + q_1 i + q_2 j + q_3 k}{\sqrt{q_0^2 + q_1^2 + q_2^2 + q_3^2}}$$

wherein Q is a quaternion vector, $q_0$, $q_1$, $q_2$, $q_3$ are scalars forming the quaternion vector, i, j, k are unit vectors in a three-dimensional coordinate system, an updated attitude matrix is as below:

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

wherein $C_b^n$ is a rotation matrix for transforming a carrier coordinate system to a navigation coordinate system,

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi+\sin\gamma\sin\psi\sin\theta & \sin\psi\cos\theta & \sin\gamma\cos\psi-\cos\gamma\sin\psi\sin\theta \\ -\cos\gamma\sin\psi+\sin\gamma\cos\psi\sin\theta & \cos\psi\cos\theta & -\sin\gamma\sin\psi-\cos\gamma\cos\psi\sin\theta \\ -\sin\gamma\cos\theta & \sin\theta & \cos\gamma\cos\theta \end{pmatrix}$$

wherein $\gamma$, $\theta$, $\psi$ are a rolling angle, a pitch angle, and the course angle respectively.

According to one aspect of the present invention, after the step of data-fusion processing the angle, the velocity, the position information and the course angle of the vehicle by the seven-dimensional EKF filtering model, and updating a motional attitude angle of the vehicle in real time, the following step is performed:

extracting the all-attitude angle data of the vehicle from updated attitude data of the vehicle, to determine a value of attitude angle data, the all-attitude angle of the vehicle including the pitch angle, the rolling angle and the course angle, wherein,

$$\begin{cases} \psi_{Principal} = \arctan(-\dfrac{C_{12}}{C_{22}}) \\ \theta_{Principal} = \arcsin C_{32} \\ \gamma_{Principal} = \arctan(-\dfrac{C_{31}}{C_{33}}) \end{cases}$$

the course angle is:

$$\psi = \begin{cases} \psi_{principle} \\ \psi_{principle}+360° & \text{When } C_{22}>0 \begin{cases} \psi_{principle} \geq 0 \\ \psi_{principle} \leq 0 \end{cases} \\ \psi_{principle}+180° & \text{When } C_{22}<0 \end{cases}$$

the pitch angle is:

$$\theta = \theta_{principle}$$

the rolling angle is:

$$\gamma = \begin{cases} \gamma_{principle}+180° \\ \gamma_{principle}-180° & \text{When } C_{33}>0 \begin{cases} \gamma_{principle} \geq 0 \\ \gamma_{principle} \leq 0 \end{cases} \\ \gamma_{principle} & \text{When } C_{33}<0 \end{cases}.$$

The beneficial effects of the invention are provided as below: the acceleration and the angular velocity of the object in motion are acquired in real time by a MEMS sensor. The angular acceleration output by the gyroscope is integrated to obtain the angle. The acceleration is integrated to calculate the velocity, which is further integrated to calculate the position information. The geomagnetic field is obtained by the geomagnetic sensor, and the course angle is calculated by the compensation algorithm and the fusion of gyroscope. Next, the attitudes are converted into a transition matrix, so that the carrier coordinate system is transformed into a navigation coordinate system. This transition matrix functions as a "mathematical platform". The SINS (Strapdown inertial navigation system) algorithm is applied to the agricultural machine, and the transition matrix is particularly important. Since the agricultural machine keeps moving, the attitudes thereof are also continuously changing. Thus, the transition matrix also needs to be continuously recalculated and updated. The conventional attitude updating algorithms include Euler angle algorithm, direction cosine algorithm, and quaternion algorithm. Compared with the Euler angle algorithm, the quaternion algorithm has no singular point. Compared with the direction cosine algorithm, the quaternion algorithm has a small calculation amount. Hence, the quaternion algorithm is very suitable for being used in the embedded product. The earth's magnetic field and the error model of the gyroscope are established in the agricultural machine plane, and a seven-dimensional EKF (Extended Kalman Filter) is established to update the attitude matrix. The quaternion and the zero offset of the gyroscope are estimated and then an observation is performed from the course angle calculated through the acceleration and the magnetic field intensity, so that a high-precision three-dimensional attitude angle can be obtained. The error compensation algorithm and the correction algorithm greatly reduce the error interference of the SINS algorithm. The MEMS sensor and the SINS algorithm ensure that the present invention has high-performance parameters. As tested by a tractor, the error of the output course angle is less than 0.1°, and the pitch angle error and the rolling angle error are less than 0.01°. Since the quaternion is used as a Kalman filtering state vector, the calculation accuracy of the target parameters can be further improved.

## Brief description of the drawings

To illustrate the technical solutions of the embodiments of the invention more clearly, the accompanying drawings required for the embodiments are briefly introduced here. Apparently, the accompanying drawings in the following description are only some embodiments of the present invention.

Fig.1 is a flow chart of a method of updating the all-attitude angle of an agricultural machine based on a nine-axis MEMS sensor according to Embodiment 1 of the invention;

Fig.2 is a flow chart of a method of updating the all-attitude angle of an agricultural machine based on a nine-axis MEMS sensor according to Embodiment 2 of the invention.

## Detailed description of the invention

The present invention will hereinafter be clearly and fully described, with reference to the accompanying drawings in the embodiments of the present invention. Apparently, the embodiments to be described are only certain embodiments of the present invention, rather than all the embodiments.

Embodiment 1:

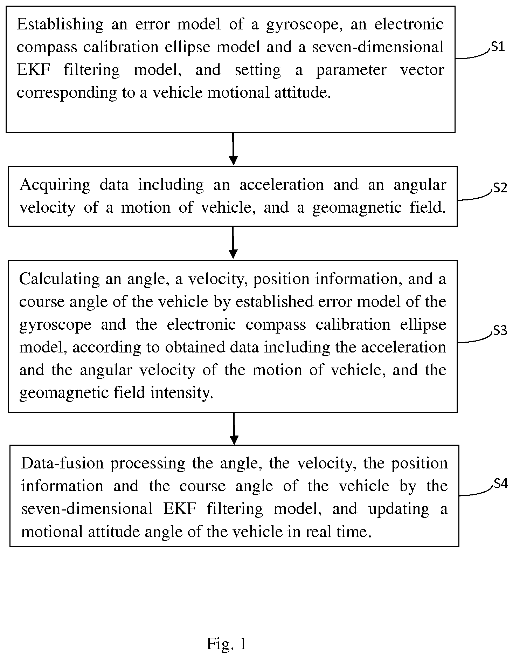

As shown in Fig. 1, a method of updating the all-attitude angle of an agricultural machine based on a nine-axis MEMS sensor includes the following steps:

Step S1: an error model of the gyroscope, an electronic compass calibration ellipse model and a seven-dimensional EKF filtering model are established, and parameter vectors corresponding to vehicle motional attitudes are set.

The step S1 of establishing an error model of the gyroscope, an electronic compass calibration ellipse model and a seven-dimensional EKF filtering model, and setting parameter vectors corresponding to vehicle motional attitudes is described in detail as below:

The angular velocity of the gyroscope is calculated in the error model of the gyroscope via an error calculation formula of the gyroscope, wherein the error calculation formula of the gyroscope is: $\omega = \omega_{ib} + b_{\omega r} + b_{\omega g}$, wherein $\omega$ is an angular velocity output by the gyroscope, $\omega_{ib}$ is a real angular velocity of the gyroscope, $b_{\omega r}$ is a zero drift of the gyroscope, and $b_{\omega g}$ is a white noise output by the gyroscope.

The magnetic field interference is eliminated by the electronic compass calibration ellipse model, wherein the electronic compass calibration ellipse model is:

$$\frac{(mx - Xoffset)^2}{Xsf^2} + \frac{(my - Yoffset)^2}{Ysf^2} = 1 \, ,$$

wherein $mx, my$ are magnetic field intensities, $Xoffset$ and $Yoffset$ are hard magnetic interferences, and $Xsf$ and $Ysf$ are soft magnetic interferences.

The vehicle attitudes are updated by the seven-dimensional EKF filtering model, wherein the seven-dimensional EKF filtering model uses an extended Kalman filter for a seven-dimensional state vector, and EKF includes a state equation and an observation equation:

$$x = f(x, \omega) + w1$$

$$y = h(x) + v1$$

The state matrix is: $x = [_q \ b_{ar}]$, wherein q is quaternion vectors q0, q1, q2, q3, $b_{wr}$ is a zero drift of the XYZ three-axis gyroscope; wherein $\omega$ is an angular velocity output by the gyroscope, $w1$ is a process noise matrix, $v1$ is an observation noise matrix, y is an observation vector, $y = [a \ \psi_{mag}]^T$, wherein a is a three-axis acceleration value, $\psi_{mag}$ is a course angle calculated by the electronic compass,

$$f(x, \omega) = \begin{bmatrix} \frac{1}{2}\begin{bmatrix} -q_1 & -q_2 & -q_3 \\ q_0 & -q_3 & q_2 \\ q_3 & q_0 & -q_1 \\ -q_2 & q_1 & q_0 \end{bmatrix}\begin{bmatrix} \omega_x - b_{\omega x} \\ \omega_y - b_{\omega y} \\ \omega_z - b_{\omega z} \end{bmatrix} \\ 0^{3\times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}(\dfrac{2(q_1 q_2 + q_0 q_3)}{q_0^2 + q_1^2 - q_2^2 - q_3^2}) \end{bmatrix}$$

Since the geomagnetic field has a weak intensity, it is susceptible to the influence of surrounding ferrous material and electromagnetic field. Therefore, it is necessary to calibrate the gyroscope first. The electronic compass calibration ellipse model is established to eliminate the interference from the magnetic field. The acquired magnetic field intensity is fitted by the least square method in the actual calibration process, such that the above parameters are obtained.

Step S2: The data including the acceleration and the angular velocity of the motion of vehicle, and the geomagnetic field intensity are acquired in real time by a nine-axis MEMS sensor.

The step S2 of acquiring the data including the acceleration and the angular velocity of the motion of vehicle, and the geomagnetic field intensity in real time by a nine-axis MEMS sensor is described in detail as below:
The angular velocity of the vehicle is obtained through a gyroscope, and the zero drift of the gyroscope is compensated.

An acceleration sensor is used to acquire the acceleration data of the vehicle.

The geomagnetic field intensity of the vehicle is acquired by a geomagnetic sensor.

Step S3: According to the obtained data including the acceleration and the angular velocity of the motion of vehicle, and the geomagnetic field intensity, the angle, the velocity, the position information, and the course angle of the vehicle are calculated by the established error model of the gyroscope and the electronic compass calibration ellipse model.

The step S3 of calculating the angle, the velocity, the position information, and the course angle of the vehicle by the established error model of the gyroscope and the electronic compass calibration ellipse model, according to the obtained data including the acceleration and the angular velocity of the motion of vehicle, and the geomagnetic field intensity, is described in detail as below.

The angle data is obtained by an integral calculation of the angular velocity by the error model of the gyroscope.

The velocity is calculated by integrating the acceleration data, and the position information is calculated by further integrating the velocity.

The course angle of the vehicle is then calculated from the geomagnetic field intensity data which is compensated by calibration parameter and corrected by the oblique angle, and both the calibration parameter and the oblique angle are calculated by the elliptical model.

The motion information of the vehicle is acquired by the MEMS sensor in real time. The angular velocity of the vehicle acquired by the gyroscope is corrected by the state estimation and the zero offset of the gyroscope. The angular velocity of the vehicle is integrated to calculate the angle increment. The geomagnetic sensor is corrected and compensated by the soft magnetism, the hard magnetism, and the oblique angle to calculate the course angle.

Step S4: The angle, the velocity, the position information and the course angle of the vehicle are data-fusion processed by the seven-dimensional EKF filtering model, and the motional attitude angle of the vehicle is updated in real time.

The step S4 of data-fusion processing the angle, the velocity, the position information and the course angle of the vehicle by the seven-dimensional EKF filtering model, and updating the motional attitude angle of the vehicle in real time, is described in detail as below.

The attitude data of the vehicle is calculated by the seven-dimensional EKF filtering model, through the quaternion attitude updating algorithm, wherein the calculation process of the EKF algorithm is as below:

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^T + Q$$

$$x_k(+) = x_k(-) + K_k \mid y_k - h(x_k(-)) \mid$$

$$P_k(+) = [I - K_k H_k] P_k(-)$$

$$H_k = \frac{\partial h}{\partial x} \mid_k$$

$$K_k = P_k(-) H_k [H_k P_k(-) H_k^T + R_k]$$

In the above formula, k is a sampling time point, $x_k$ is a system state estimation, (-) is the previous time point, (+) is the later time point, $\Phi_k$ is a state transition matrix, $Pk$ is a minimum mean square error matrix, $Q$ is a covariance matrix corresponding to the state vector, $Kk$ is an error gain, $yk$ is an observation vector, $Hk$ is a transition matrix for the observation equation, $Rk$ is a covariance matrix corresponding to the observation vector.

$$Q = \frac{q_0 + q_1 i + q_2 j + q_3 k}{\sqrt{q_0^2 + q_1^2 + q_2^2 + q_3^2}}$$

In the above formula, Q is a quaternion vector, q0, q1, q2, q3 are scalars forming a quaternion vector, i, j, k are unit vectors in the three-dimensional coordinate system. The updated attitude matrix is as below:

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

In the above formula, $C_b^n$ is a rotation matrix for transforming a carrier coordinate system to a navigation coordinate system.

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi + \sin\gamma\sin\psi\sin\theta & \sin\psi\cos\theta & \sin\gamma\cos\psi - \cos\gamma\sin\psi\sin\theta \\ -\cos\gamma\sin\psi + \sin\gamma\cos\psi\sin\theta & \cos\psi\cos\theta & -\sin\gamma\sin\psi - \cos\gamma\cos\psi\sin\theta \\ -\sin\gamma\cos\theta & \sin\theta & \cos\gamma\cos\theta \end{pmatrix}$$

In the above formula, $\gamma$, $\theta$, $\psi$ are a rolling angle, a pitch angle and a course angle respectively.

In the above formula, the nine-axis MEMS sensor is composed of a three-axis gyroscope, a three-axis accelerometer, and a three-axis geomagnetic sensor.

Embodiment 2:

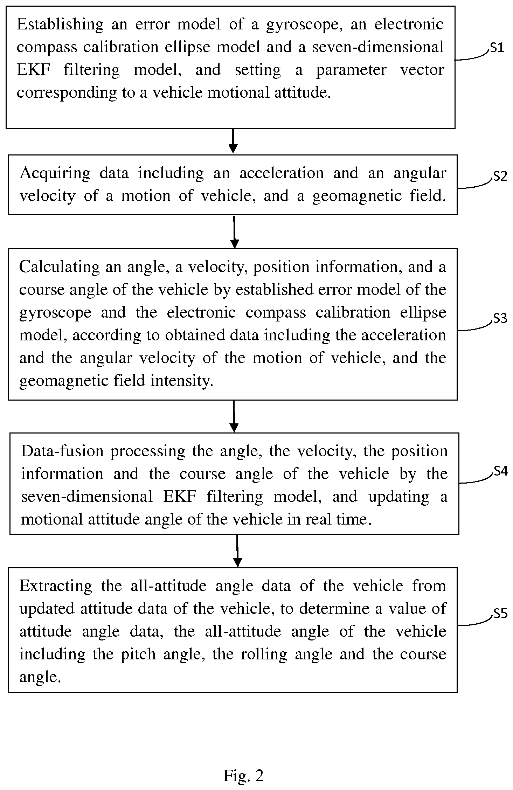

As shown in Fig. 2, a method of updating the all-attitude angle of an agricultural machine based on a nine-axis MEMS sensor is provided. The method includes the following steps:

Step S1: an error model of the gyroscope, an electronic compass calibration ellipse model and a seven-dimensional EKF filtering model are established, and parameter vectors corresponding to vehicle motional attitudes are set.

The step S1 of establishing an error model of the gyroscope, an electronic compass calibration ellipse model and a seven-dimensional EKF filtering model, and setting parameter vectors corresponding to vehicle motional attitudes is described in detail as below:

The angular velocity of the gyroscope is calculated in the error formula of the gyroscope via an error calculation formula of the gyroscope, wherein the error calculation formula of the gyroscope is: $\omega = \omega_{ib} + b_{\omega r} + b_{\omega g}$, wherein $\omega$ is an angular velocity output by the gyroscope, $\omega_{ib}$ is a real angular velocity of the gyroscope, $b_{\omega r}$ is a zero drift of the gyroscope, and $b_{\omega g}$ is a white noise output by the gyroscope.

The magnetic field interference is eliminated by the electronic compass calibration ellipse model, wherein the electronic compass calibration ellipse model is:

$$\frac{(mx - Xoffset)^2}{Xsf^2} + \frac{(my - Yoffset)^2}{Ysf^2} = 1 \ ,$$

wherein $mx, my$ are magnetic field intensities, $Xoffset$ and $Yoffset$ are hard magnetic interferences, and $Xsf$ and $Ysf$ are soft magnetic interferences.

The vehicle attitudes are updated by the seven-dimensional EKF filtering model, wherein the seven-dimensional EKF filtering model is an extended Kalman filter of a seven-dimensional state vector, and EKF includes a state equation and an observation equation:

$$x = f(x, \omega) + w1$$

$$y = h(x) + v1$$

The state matrix is: $x = [q \ b_{ar}]$, wherein q is quaternion vectors q0, q1, q2, q3, $b_{\omega r}$ is a zero drift of the XYZ three-axis gyroscope. In the formula, $\omega$ is an angular velocity output by the gyroscope, $w1$ is a process noise matrix, $v1$ is an observation noise matrix, y is an observation vector, $y = [a \ \psi_{mag}]^T$, wherein a is a three-axis acceleration value, $\psi_{mag}$ is a course angle calculated by the electronic compass,

$$f(x, \omega) = \begin{bmatrix} \frac{1}{2} \begin{bmatrix} -q_1 & -q_2 & -q_3 \\ q_0 & -q_3 & q_2 \\ q_3 & q_0 & -q_1 \\ -q_2 & q_1 & q_0 \end{bmatrix} \begin{bmatrix} \omega_x - b_{\omega rx} \\ \omega_y - b_{\omega ry} \\ \omega_z - b_{\omega rz} \end{bmatrix} \\ 0^{3 \times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}(\dfrac{2(q_1 q_2 + q_0 q_3)}{q_0^2 + q_1^2 - q_2^2 - q_3^2}) \end{bmatrix}$$

Since the geomagnetic field has a weak intensity, it is susceptible to the influence of surrounding ferrous material and electromagnetic fields. Therefore, it is necessary to calibrate the gyroscope first. The electronic compass calibration ellipse model is established to eliminate the interference from the magnetic field. The acquired magnetic field intensity is fitted by the least square method in the actual calibration process, such that the above parameters are obtained.

Step S2: The data including the acceleration, and the angular velocity of the motion of vehicle, and the geomagnetic field intensity are acquired in real time by a nine-axis MEMS sensor.

The step S2 of acquiring the data including the acceleration and the angular velocity of the motion of vehicle, and the geomagnetic field intensity in real time by a nine-axis MEMS sensor is described in detail as below:
The angular velocity of the vehicle is obtained through a gyroscope, and the zero drift of the gyroscope is compensated.

An acceleration sensor is used to acquire the acceleration data of the vehicle.

The geomagnetic field intensity of the vehicle is acquired by a geomagnetic sensor.

Step S3: According to the obtained data including the acceleration and the angular velocity of the motion of vehicle, and the geomagnetic field intensity, the angle, the velocity, the position information, and the course angle of the vehicle are calculated by the established error model of the gyroscope and the electronic compass calibration ellipse model.

The step S3 of calculating the angle, the velocity, the position information, and the course angle of the vehicle by the established error model of the gyroscope and the electronic compass calibration ellipse model, according to the obtained data including the acceleration and the angular velocity of the motion of vehicle, and the geomagnetic field intensity, is described in detail as below.

The angle data is obtained by an integral calculation of the angular velocity by the error model of the gyroscope.

The velocity is calculated by integrating the acceleration data, and the position information is calculated by further integrating the velocity.

The course angle of the vehicle is then calculated from the geomagnetic field intensity data which is compensated by calibration parameter and corrected by the oblique angle, and both the calibration parameter and the oblique angle are calculated by the elliptical model.

The motion information of the vehicle is acquired by the MEMS sensor in real time. The angular velocity of the vehicle acquired by the gyroscope is corrected by the state estimation and the zero offset of the gyroscope. The angular velocity of the vehicle is integrated to calculate the angle increment. The geomagnetic sensor is corrected and compensated by the soft magnetism, the hard magnetism, and the oblique angle to calculate the course angle.

Step S4: The angle, the velocity, the position information and the course angle of the vehicle are data-fusion processed by the seven-dimensional EKF filtering model, and the motional attitude angle of the vehicle is updated in real time.

The step S4 of data-fusion processing the angle, the velocity, the position information and the course angle of the vehicle by the seven-dimensional EKF filtering model, and updating the motional attitude angle of the vehicle in real time, is described in detail as below.

The attitude data of the vehicle is calculated by the seven-dimensional EKF filtering model, through the quaternion attitude updating algorithm, wherein the calculation process of the EKF algorithm is as below:

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^T + Q$$

$$x_k(+) = x_k(-) + K_k \mid y_k - h(x_k(-)) \mid$$

$$P_k(+) = [I - K_k H_k] P_k(-)$$

$$H_k = \frac{\partial h}{\partial x}\big|_k$$

$$K_k = P_k(-)H_k[H_k P_k(-)H_k^T + R_k]$$

In the above formula, k is a sampling time point, $x_k$ is a system state estimation, (-) is the previous time point, (+) is the later time point, $\Phi_k$ is a state transition matrix, $Pk$ is a minimum mean square error matrix, $Q$ is a covariance matrix corresponding to the state vector, $Kk$ is an error gain, $yk$ is an observation vector, $Hk$ is a transition matrix for the observation equation, $Rk$ is a covariance matrix corresponding to the observation vector.

$$Q = \frac{q_0 + q_1 i + q_2 j + q_3 k}{\sqrt{q_0^2 + q_1^2 + q_2^2 + q_3^2}}$$

In the above formula, Q is a quaternion vector, q0, q1, q2, q3 are scalars forming a quaternion vector, i, j, k are unit vectors in the three-dimensional coordinate system, the updated attitude matrix is as below:

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

In the above formula, $C_b^n$ is a rotation matrix for transforming a carrier coordinate system to a navigation coordinate system.

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi + \sin\gamma\sin\psi\sin\theta & \sin\psi\cos\theta & \sin\gamma\cos\psi - \cos\gamma\sin\psi\sin\theta \\ -\cos\gamma\sin\psi + \sin\gamma\cos\psi\sin\theta & \cos\psi\cos\theta & -\sin\gamma\sin\psi - \cos\gamma\cos\psi\sin\theta \\ -\sin\gamma\cos\theta & \sin\theta & \cos\gamma\cos\theta \end{pmatrix}$$

In the above formula, $\gamma$, $\theta$, $\psi$ are a rolling angle, a pitch angle, and a course angle respectively.
In the above formula, the nine-axis MEMS sensor is composed of a three-axis gyroscope, a three-axis accelerometer, and a three-axis geomagnetic sensor.
Step S5: The all-attitude angle data of the vehicle is extracted from the updated attitude data of the vehicle, to determine the value of the attitude angle data. The all-attitude angle of the vehicle includes a pitch angle, a rolling angle and a course angle, wherein,

$$\begin{cases} \psi_{Principal} = \arctan\left(-\frac{C_{12}}{C_{22}}\right) \\ \theta_{Principal} = \arcsin C_{32} \\ \gamma_{Principal} = \arctan\left(-\frac{C_{31}}{C_{33}}\right) \end{cases}$$

The course angle is:

$$\psi = \begin{cases} \psi_{\text{principle}} \\ \psi_{\text{principle}} + 360° & \text{When } C_{22} > 0 \begin{cases} \psi_{\text{principle}} \geq 0 \\ \psi_{\text{principle}} < 0 \end{cases} \\ \psi_{\text{principle}} + 180° & \text{When } C_{22} < 0 \end{cases}$$

The pitch angle is:

$$\theta = \theta_{\text{principle}}$$

The rolling angle is:

$$\gamma = \begin{cases} \gamma_{\text{principle}} + 180° \\ \gamma_{\text{principle}} - 180° & \text{When } C_{33} > 0 \begin{cases} \gamma_{\text{principle}} \geq 0 \\ \gamma_{\text{principle}} < 0 \end{cases} \\ \gamma_{\text{principle}} & \text{When } C_{33} < 0 \end{cases}$$

The all-attitude attitude angle of the vehicle can be extracted from the updated and calculated attitude matrix $C_b^n$, and the all-attitude attitude angle includes the pitch angle, the rolling angle and the course angle. Since the pitch angle $\theta$ is defined within the interval of [-90°, +90°], which is consistent with the principal value of an inverse sine function, there is no problem of multi-value. The rolling angle $\gamma$ is defined within the interval of [180°, 180°]. The course angle $\psi$ is defined within the interval of [0°, 360°]. Hence, there are problems of multi-value for both $\gamma$ and $\psi$. After the principle value is calculated, the specific quadrant can be determined by the elements in $C_b^n$.

The advantages of the invention are as below: the acceleration and the angular velocity of the motion of the object are acquired in real time by a MEMS sensor. The angular acceleration output by the gyroscope is integrated to obtain the angle. The acceleration is integrated to calculate the velocity, which is further integrated to calculate the position information. The geomagnetic field is obtained by the geomagnetic sensor, and the course angle is calculated by the compensation algorithm and the fusion of gyroscope. Next, the attitudes are converted into a transition matrix, so that the carrier coordinate system is transformed into a navigation coordinate system. This transition matrix functions as a "mathematical platform". The SINS (Strapdown inertial navigation system) algorithm is applied to the agricultural machine, and the transition matrix is particularly important. Since the agricultural machine keeps moving, the attitudes thereof are also continuously changing. Thus, the transition matrix also needs to be continuously recalculated and updated. The conventional attitude updating algorithms include Euler angle algorithm, direction cosine algorithm, and quaternion algorithm. Compared with the Euler angle algorithm, the quaternion algorithm has no singular point. Compared with the direction cosine algorithm, the quaternion algorithm has a small calculation amount. Hence, the quaternion algorithm is very suitable for being used in the embedded product. The geomagnetic field and the error model of the gyroscope are established in the agricultural machine plane, and a seven-dimensional EKF (Extended Kalman Filter) is established to update the attitude matrix. The quaternion and the zero offset of the gyroscope are estimated. Next, an observation is performed from the course angle calculated through the acceleration and the magnetic field intensity, so that a high-precision three-dimensional attitude angle can be obtained. The error compensation algorithm and the correction algorithm greatly reduce the error interference of the SINS algorithm. The MEMS sensor and the SINS algorithm ensure that the present invention has high-performance parameters. As tested by a tractor, the error of the output course angle is less than 0.1°, and the pitch angle error and the rolling angle error are less than 0.01°. Since the quaternion is used as a Kalman filtering state vector, the calculation accuracy of the target parameters can be further improved.

**Claims**

1. A method of updating an all-attitude angle of an agricultural machine based on a nine-axis MEMS sensor, wherein the method of updating the all-attitude angle of an agricultural machine based on a nine-axis MEMS sensor comprising the following steps:

   establishing an error model of a gyroscope, an electronic compass calibration ellipse model and a seven-dimensional EKF filtering model, and setting a parameter vector corresponding to a vehicle motional attitude (S1);
   acquiring data including an acceleration and an angular velocity of a motion of vehicle, and a geomagnetic field (S2) intensity in real time by a nine-axis MEMS sensor;
   calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity (S3); and
   data-fusion processing the angle, the velocity, the position information and the course angle of the vehicle by the seven-dimensional EKF filtering model, and updating a motional attitude angle of the vehicle in real time (S4);
   wherein the nine-axis MEMS sensor is composed of a three-axis gyroscope, a three-axis acceleration sensor, and a three-axis geomagnetic sensor,
   wherein the step (S1) of establishing an error model of a gyroscope, an electronic compass calibration ellipse model and a seven-dimensional EKF filtering model, and setting a parameter vector corresponding to a vehicle motional attitude is described in detail as below:
   calculating the angular velocity of the gyroscope in the error model of the gyroscope via an error calculation formula of the gyroscope; wherein the error calculation formula of the gyroscope is: $\omega = \omega_{ib} + b_{\omega r} + b_{\omega g}$, wherein $\omega$ is an angular velocity output by the gyroscope, $\omega_{ib}$ is a real angular velocity of the gyroscope, $b_{\omega r}$ is a zero drift of the gyroscope, and $b_{\omega g}$ is a white noise output by the gyroscope;
   eliminating a magnetic field interference by the electronic compass calibration ellipse model; wherein the electronic compass calibration ellipse model is:

$$\frac{(mx - Xoffset)^2}{Xsf^2} + \frac{(my - Yoffset)^2}{Ysf^2} = 1 \quad,$$

   wherein $mx$, $my$ are magnetic field intensities, $Xoffset$ and $Yoffset$ are hard magnetic interferences, and $Xsf$ and $Ysf$ are soft magnetic interferences;
   updating the vehicle attitude by the seven-dimensional EKF filtering model, wherein, the seven-dimensional EKF filtering model uses an extended Kalman filter for a seven-dimensional state vector, and EKF includes a state equation and an observation equation:

$$x = f(x, \omega) + w1$$

$$y = h(x) + v1$$

   wherein the state matrix is $x = [q\ b_{ar}]$, q is quaternion vectors $q_0$, $q_1$, $q_2$, $q_3$, and $b_{\omega r}$ is a zero drift of the-three-axis gyroscope, wherein $\omega$ is the angular velocity output by the gyroscope, $w1$ is a process noise matrix, $v1$ is an observation noise matrix, $y$ is an observation vector, $y = [a\ \psi_{mag}]^T$, wherein a is a three-axis acceleration value, $\psi_{mag}$ is a course angle calculated by the electronic compass,

$$f(x,\omega) = \begin{bmatrix} \dfrac{1}{2} \begin{bmatrix} -q_1 & -q_2 & -q_3 \\ q_0 & -q_3 & q_2 \\ q_3 & q_0 & -q_1 \\ -q_2 & q_1 & q_0 \end{bmatrix} \begin{bmatrix} \omega_x - b_{\omega x} \\ \omega_y - b_{\omega y} \\ \omega_z - b_{\omega z} \end{bmatrix} \\ 0^{3\times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}\left(\dfrac{2(q_1 q_2 + q_0 q_3)}{q_0^2 + q_1^2 - q_2^2 - q_3^2}\right) \end{bmatrix}$$

2. The method of updating an all-attitude angle of an agricultural machine based on a nine-axis MEMS sensor of claim 1, **characterized in that**, the step (S2) of acquiring data including an acceleration and an angular velocity of a motion of vehicle, and an geomagnetic field intensity in real time by a nine-axis MEMS sensor is described in detail as below:

   obtaining the angular velocity of the vehicle through the gyroscope, and compensating the zero drift of the gyroscope;
   acquiring the acceleration of the vehicle by an acceleration sensor; and
   acquiring the geomagnetic field intensity of the vehicle by the geomagnetic sensor.

3. The method of updating an all-attitude angle of an agricultural machine based on a nine-axis MEMS sensor of claim 2, **characterized in that**, the step (S3) of calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity is described in detail as below:

   obtaining the angle by an integral calculation of the angular velocity by the error model of the gyroscope;
   calculating the velocity by integrating the acceleration, and the position information is calculated by further integrating the velocity; and
   calculating the course angle of the vehicle from the geomagnetic field intensity which is compensated by a calibration parameter and corrected by an oblique angle, and both the calibration parameter and the oblique angle being calculated by the elliptical model.

4. The method of updating an all-attitude angle of an agricultural machine based on a nine-axis MEMS sensor of claim 3, **characterized in that**, the step (S4) of data-fusion processing the angle, the velocity, the position information and the course angle of the vehicle by the seven-dimensional EKF filtering model, and updating the motional attitude angle of the vehicle in real time is described in detail as below:

   calculating the motional attitude angle of the vehicle by the seven-dimensional EKF filtering model, through a quaternion attitude updating algorithm, wherein a calculation process of the EKF algorithm is as below:

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^T + Q$$

$$x_k(+) = x_k(-) + K_k \, | \, y_k - h(x_k(-)) \, |$$

$$P_k(+) = [I - K_k H_k] P_k(-)$$

$$H_k = \frac{\partial h}{\partial x}|_k$$

$$K_k = P_k(-) H_k [H_k P_k(-) H_k^T + R_k]$$

wherein k is a sampling time point, $x_k$ is a system state estimation, (-) is a previous time point, (+) is a later time point, $\Phi_k$ is a state transition matrix, $P_k$ is a minimum mean square error matrix, $Q$ is a covariance matrix corresponding to the state vector, $K_k$ is an error gain, $y_k$ is an observation vector, $H_k$ is a transition matrix for the observation equation, $R_k$ is a covariance matrix corresponding to the observation vector;

$$Q = \frac{q_0 + q_1 i + q_2 j + q_3 k}{\sqrt{q_0^2 + q_1^2 + q_2^2 + q_3^2}}$$

wherein Q is a quaternion vector, $q_0$, $q_1$, $q_2$, $q_3$ are scalars forming the quaternion vector, i, j, k are unit vectors in a three-dimensional coordinate system, an updated attitude matrix is as below:

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

wherein $C_b^n$ is a rotation matrix for transforming a carrier coordinate system to a navigation coordinate system,

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi + \sin\gamma\sin\psi\sin\theta & \sin\psi\cos\theta & \sin\gamma\cos\psi - \cos\gamma\sin\psi\sin\theta \\ -\cos\gamma\sin\psi + \sin\gamma\cos\psi\sin\theta & \cos\psi\cos\theta & -\sin\gamma\sin\psi - \cos\gamma\cos\psi\sin\theta \\ -\sin\gamma\cos\theta & \sin\theta & \cos\gamma\cos\theta \end{pmatrix}$$

wherein $\gamma$, $\theta$, $\psi$ are a rolling angle, a pitch angle, and the course angle respectively.

5. The method of updating an all-attitude angle of an agricultural machine based on a nine-axis MEMS sensor of claim 4, **characterized in that**, after the step (S4) of data-fusion processing the angle, the velocity, the position information and the course angle of the vehicle by the seven-dimensional EKF filtering model, and updating the motional attitude angle of the vehicle in real time, the following step is performed:

extracting the all-attitude angle of the vehicle from updated motional attitude angle of the vehicle, to determine a value of the all-attitude angle, the all-attitude angle of the vehicle including the pitch angle, the rolling angle and the course angle (S5), wherein,

$$\begin{cases} \psi_{\text{Principal}} = \arctan\left(-\dfrac{C_{12}}{C_{22}}\right) \\ \theta_{\text{Principal}} = \arcsin C_{32} \\ \gamma_{\text{Principal}} = \arctan\left(-\dfrac{C_{31}}{C_{33}}\right) \end{cases}$$

the course angle is:

$$\psi = \begin{cases} \psi_{\text{principle}} \\ \psi_{\text{principle}} + 360° & \text{When } C_{22} > 0 \begin{cases} \psi_{\text{principle}} > 0 \\ \psi_{\text{principle}} < 0 \end{cases} \\ \psi_{\text{principle}} + 180° & \text{When } C_{22} < 0 \end{cases}$$

the pitch angle is:

$$\theta = \theta_{\text{principle}}$$

the rolling angle is:

$$\gamma = \begin{cases} \gamma_{\text{principle}} + 180° \\ \gamma_{\text{principle}} - 180° & \text{When } C_{33} > 0 \begin{cases} \gamma_{\text{principle}} > 0 \\ \gamma_{\text{principle}} < 0 \end{cases} \\ \gamma_{\text{principle}} & \text{When } C_{33} < 0 \end{cases}$$

**Patentansprüche**

1. Verfahren zum Aktualisieren eines Alllagenwinkels einer landwirtschaftlichen Maschine basierend auf einem neunachsigen MEMS-Sensor, wobei das Verfahren zum Aktualisieren des Alllagenwinkels einer landwirtschaftlichen Maschine basierend auf einem neunachsigen MEMS-Sensor die folgenden Schritte umfasst:

   Erstellen eines Fehlermodells eines Gyroskops, eines elektronischen Kompasskalibrierungsellipsenmodells und eines siebendimensionalen EKF-Filtermodells und Einstellen eines Parametervektors, der einer Fahrzeugbewegungslage (S1) entspricht;
   Erfassen von Daten, einschließlich einer Beschleunigung und einer Winkelgeschwindigkeit einer Fahrzeugbewegung und einer Intensität des Erdmagnetfelds (S2) in Echtzeit durch einen neunachsigen MEMS-Sensor;
   Berechnen eines Winkels, einer Geschwindigkeit, einer Positionsinformation und eines Kurswinkels des Fahrzeugs durch ein etabliertes Fehlermodell des Gyroskops und des elektronischen Kompasskalibrierungsellipsenmodells gemäß erhaltenen Daten, einschließlich der Beschleunigung und der Winkelgeschwindigkeit der Bewegung des Fahrzeugs, und die geomagnetische Feldstärke (S3); und
   Datenfusionsverarbeitung des Winkels, der Geschwindigkeit, der Positionsinformation und des Kurswinkels des Fahrzeugs durch das siebendimensionale EKF-Filtermodell und Aktualisierung eines Bewegungslagewinkels des Fahrzeugs in Echtzeit (S4);
   wobei der neunachsige MEMS-Sensor aus einem dreiachsigen Gyroskop, einem dreiachsigen Beschleunigungssensor und einem dreiachsigen geomagnetischen Sensor besteht,
   wobei der Schritt (S1) des Erstellens eines Fehlermodells eines Gyroskops, eines elektronischen Kompasskalibrierungsellipsenmodells und eines siebendimensionalen EKF-Filtermodells und des Einstellens eines Parametervektors, der einer Bewegungslage des Fahrzeugs entspricht, im Detail wie folgt beschrieben wird:

Berechnen der Winkelgeschwindigkeit des Gyroskops im Fehlermodell des Gyroskops über eine Fehlerberechnungsformel des Gyroskops; wobei die Fehlerberechnungsformel des Gyroskops lautet: $\omega = \omega_{ib} + b_{\omega r} + b_{\omega g}$, wobei $\omega$ eine vom Gyroskop ausgegebene Winkelgeschwindigkeit ist, $\omega_{ib}$ eine reale Winkelgeschwindigkeit des Gyroskops ist, $b_{\omega r}$ eine Nulldrift des Gyroskops ist und $b_{\omega g}$ ist ein vom Gyroskop ausgegebenes weißes Rauschen;

Eliminieren einer Magnetfeldstörung durch das elektronische Kompasskalibrierungsellipsenmodell; wobei das elektronische Kompasskalibrierungsellipsenmodell beträgt:

$$\frac{(mx - Xoffset)^2}{Xsf^2} + \frac{(my - Yoffset)^2}{Ysf^2} = 1 \; ,$$

wobei $mx$, $my$ Magnetfeldintensitäten sind, $Xoffset$ und $Yoffset$ harte magnetische Interferenzen sind und $Xsf$ und $Ysf$ weichmagnetische Interferenzen sind;

Aktualisieren der Fahrzeuglage durch das siebendimensionale EKF-Filtermodell, wobei das siebendimensionale EKF-Filtermodell ein erweitertes Kalman-Filter für einen siebendimensionalen Zustandsvektor verwendet und EKF eine Zustandsgleichung und eine Beobachtungsgleichung enthält:

$$x = f(x, \omega) + w1$$

$$y = h(x) + v1$$

wobei die Zustandsmatrix is $x = [q \; b_{ar}]$,, q Quaternionsvektoren $q_0$, q1, $q_2$, $q_3$ ist und $b_{\omega r}$ eine Nulldrift des dreiachsigen Gyroskops ist, wobei $\omega$ die vom Gyroskop ausgegebene Winkelgeschwindigkeit ist, $w1$ eine Prozessrauschmatrix ist, $v1$ eine Beobachtungsrauschmatrix ist, $y$ eine Beobachtungsvektor ist, $y = [a \; \psi_{mag}]^T$, wobei $a$ ein dreiachsiger Beschleunigungswert ist, $\psi_{mag}$ ein vom elektronischen Kompass berechneter Kurswinkel ist,

$$f(x, \omega) = \begin{bmatrix} \frac{1}{2} \begin{bmatrix} -q_1 & -q_2 & -q_3 \\ q_0 & -q_3 & q_2 \\ q_3 & q_0 & -q_1 \\ -q_2 & q_1 & q_0 \end{bmatrix} \begin{bmatrix} \omega_x - b_{\omega x} \\ \omega_y - b_{\omega y} \\ \omega_z - b_{\omega z} \end{bmatrix} \\ 0^{3 \times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}(\frac{2(q_1 q_2 + q_0 q_3)}{q_0^2 + q_1^2 - q_2^2 - q_3^2}) \end{bmatrix}$$

2. Das Verfahren zum Aktualisieren eines Alllagenwinkels einer landwirtschaftlichen Maschine basierend auf einem neunachsigen MEMS-Sensor nach Anspruch 1, **gekennzeichnet dadurch, dass** der Schritt (S2) des Erfassens von Daten einschließlich einer Beschleunigung und einer Winkelgeschwindigkeit einer Fahrzeugbewegung, und einer geomagnetische Feldstärke in Echtzeit durch einen neunachsigen MEMS-Sensor wird im Detail wie folgt beschrieben:

Erhalten der Winkelgeschwindigkeit des Fahrzeugs durch das Gyroskop und Kompensieren der Nulldrift des Gyroskops;

Erfassen der Beschleunigung des Fahrzeugs durch einen Beschleunigungssensor; und

Erfassung der geomagnetischen Feldstärke des Fahrzeugs durch den geomagnetischen Sensor.

3. Das Verfahren zum Aktualisieren eines Alllagenwinkels einer landwirtschaftlichen Maschine basierend auf einem neunachsigen MEMS-Sensor nach Anspruch 2, **gekennzeichnet dadurch, dass** der Schritt (S3) des Berechnens eines Winkels, einer Geschwindigkeit, Positionsinformationen und eines Kurswinkels des Fahrzeugs durch etabliertes Fehlermodell des Gyroskops und des elektronischen Kompasskalibrierungsellipsenmodells gemäß erhaltenen Daten, einschließlich der Beschleunigung und der Winkelgeschwindigkeit der Bewegung des Fahrzeugs, und der Intensität des geomagnetischen Feldes im Detail wie folgt beschrieben wird:

Erhalten des Winkels durch eine integrale Berechnung der Winkelgeschwindigkeit durch das Fehlermodell des Gyroskops;

Berechnen der Geschwindigkeit durch Integrieren der Beschleunigung, und die Positionsinformation wird durch weiteres Integrieren der Geschwindigkeit berechnet; und

Berechnen des Kurswinkels des Fahrzeugs aus der geomagnetischen Feldstärke, die durch einen Kalibrierungsparameter kompensiert und durch einen schrägen Winkel korrigiert wird, und sowohl der Kalibrierungsparameter als auch der schräge Winkel werden durch das elliptische Modell berechnet.

4. Das Verfahren zum Aktualisieren eines Alllagenwinkels einer landwirtschaftlichen Maschine basierend auf einem neunachsigen MEMS-Sensor nach Anspruch 3, **gekennzeichnet dadurch, dass** der Schritt (S4) der Datenfusionsverarbeitung des Winkels, der Geschwindigkeit, der Positionsinformation und des Kurswinkels des Fahrzeugs durch das siebendimensionale EKF-Filtermodell und die Aktualisierung des Bewegungslagenwinkels des Fahrzeugs in Echtzeit im Folgenden wie folgt beschrieben wird:

Berechnen des Bewegungslagenwinkels des Fahrzeugs durch das siebendimensionale EKF-Filtermodell durch einen Quaternionslagenaktualisierungsalgorithmus, wobei ein Berechnungsprozess des EKF-Algorithmus wie folgt ist:

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^{T} + Q$$

$$x_k(+) = x_k(-) + K_k \lfloor y_k - h(x_k(-)) \rfloor$$

$$P_k(+) = [I - K_k H_k] P_k(-)$$

$$H_k = \frac{\partial h}{\partial x}|_k$$

$$K_k = P_k(-) H_k [H_k P_k(-) H_k^{T} + R_k]$$

wobei $k$ ein Abtastzeitpunkt ist, $x_k$ eine Systemzustandsschätzung ist, (-) ein vorheriger Zeitpunkt ist, (+) ein späterer Zeitpunkt ist, $\Phi_k$ eine Zustandsübergangsmatrix ist, $P_k$ eine minimale mittlere quadratische Fehlermatrix ist, $Q$ eine Kovarianzmatrix ist, die dem Zustandsvektor entspricht, $K_k$ eine Fehlerverstärkung ist, $y_k$ ein Beobachtungsvektor ist, $Hk$ eine Übergangsmatrix für die Beobachtungsgleichung ist, $R_k$ eine Kovarianzmatrix ist,

die dem Beobachtungsvektor entspricht;

$$Q = \frac{q_0 + q_1 i + q_2 j + q_3 k}{\sqrt{q_0^2 + q_1^2 + q_2^2 + q_3^2}}$$

wobei Q ein Quaternionsvektor ist, $q_0$, $q_1$, $q_2$, $q_3$ Skalare sind, die den Quaternionsvektor bilden, *i, j, k* Einheitsvektoren in einem dreidimensionalen Koordinatensystem sind, eine aktualisierte Lagematrix wie folgt ist:

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

wobei $C_b^n$ eine Rotationsmatrix zum Transformieren eines Trägerkoordinatensystems in ein Navigationskoordinatensystem ist,

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi + \sin\gamma\sin\psi\sin\theta & \sin\psi\cos\theta & \sin\gamma\cos\psi - \cos\gamma\sin\psi\sin\theta \\ -\cos\gamma\sin\psi + \sin\gamma\cos\psi\sin\theta & \cos\psi\cos\theta & -\sin\gamma\sin\psi - \cos\gamma\cos\psi\sin\theta \\ -\sin\gamma\cos\theta & \sin\theta & \cos\gamma\cos\theta \end{pmatrix}$$

wobei *y, θ, ψ* jeweils ein Rollwinkel, ein Nickwinkel und der Kurswinkel sind.

5. Verfahren zum Aktualisieren eines Alllagenwinkels einer landwirtschaftlichen Maschine basierend auf einem neunachsigen MEMS-Sensor nach Anspruch 4, **gekennzeichnet dadurch, dass** nach dem Schritt (S4) der Datenfusionsverarbeitung des Winkels, der Geschwindigkeit, der Positionsinformation und des Kurswinkels des Fahrzeugs durch das siebendimensionale EKF-Filtermodell und der Aktualisierung des Bewegungslagenwinkels des Fahrzeugs in Echtzeit der folgende Schritt durchgeführt wird:
Extrahieren des Alllagenwinkels des Fahrzeugs aus dem aktualisierten Bewegungslagenwinkel des Fahrzeugs, um einen Wert des Alllagenwinkels, des Alllagenwinkels des Fahrzeugs, einschließlich des Nickwinkels, des Rollwinkels und des Kurswinkels (S5) zu bestimmen, wobei,

$$\begin{cases} \psi_{\text{Prinzipielle}} = \arctan(-\dfrac{C_{12}}{C_{22}}) \\ \theta_{\text{Prinzipielle}} = \arcsin C_{32} \\ \gamma_{\text{Prinzipielle}} = \arctan(-\dfrac{C_{31}}{C_{33}}) \end{cases}$$

der Kurswinkel beträgt:

$$\psi = \begin{cases} \psi_{\text{Prinzipielle}} \\ \psi_{\text{Prinzipielle}} + 360° & \text{Wenn} \quad C_{22} > 0 \begin{cases} \psi_{\text{Prinzipielle}} > 0 \\ \psi_{\text{Prinzipielle}} < 0 \end{cases} \\ \psi_{\text{Prinzipielle}} + 180° & \text{Wenn} \quad C_{22} < 0 \end{cases}$$

der Nickwinkel beträgt:

$$\theta = \theta_{\text{Prinzipielle}}$$

der Rollwinkel beträgt:

$$\gamma = \begin{cases} \gamma_{\text{Prinzipielle}} + 180° \\ \gamma_{\text{Prinzipielle}} - 180° & \text{Wenn} \quad C_{33} > 0 \begin{cases} \gamma_{\text{Prinzipielle}} > 0 \\ \gamma_{\text{Prinzipielle}} < 0 \end{cases} \\ \gamma_{\text{Prinzipielle}} & \text{Wenn} \quad C_{33} < 0 \end{cases}$$

.

## Revendications

1. Procédé de mise à jour d'un angle toutes-attitudes d'une machine agricole basé sur un capteur MEMS à neuf axes, dans lequel le procédé de mise à jour de l'angle toutes-attitudes d'une machine agricole basée sur un capteur MEMS à neuf axes comprend les étapes suivantes :

   établir un modèle d'erreur d'un gyroscope, un modèle d'ellipse d'étalonnage d'un compas électronique et un modèle de filtrage EKF à sept dimensions régler un vecteur paramètre correspondant à une attitude cinétique du véhicule (S1) ;
   acquérir des données incluant une accélération et une vitesse angulaire d'un mouvement de véhicule, et une intensité de champ géomagnétique (S2) en temps réel par un capteur MEMS à neuf axes ;
   calculer un angle, une vitesse, des informations sur la position et un angle de course du véhicule en utilisant le modèle d'erreur établi du gyroscope et le modèle d'ellipse d'étalonnage du compas électronique, en fonction des données obtenues incluant l'accélération et la vitesse angulaire du mouvement du véhicule, et l'intensité du champ géomagnétique (S3); et
   traiter par fusion de données l'angle, la vitesse, les informations de position et l'angle de course du véhicule au moyen du modèle de filtrage EKF à sept dimensions, et mettre à jour un angle d'attitude cinétique du véhicule en temps réel (S4) ;
   dans lequel le capteur MEMS à neuf axes est composé d'un gyroscope à trois axes, d'un capteur d'accélération à trois axes et d'un capteur géomagnétique à trois axes,
   dans lequel l'étape (S1) d'établir un modèle d'erreur d'un gyroscope, un modèle d'ellipse d'étalonnage d'un compas électronique et un modèle de filtrage EKF à sept dimensions régler un vecteur paramètre correspondant à une attitude cinétique du véhicule est décrite en détail ci-dessous:

   calculer la vitesse angulaire du gyroscope dans le modèle d'erreur du gyroscope via une formule de calcul d'erreur du gyroscope ; dans lequel la formule de calcul d'erreur du gyroscope est: $\omega = \omega_{ib} + b_{\omega r} + b_{\omega g}$, dans lequel $\omega$ est une vitesse angulaire sortie par le gyroscope, $\omega_{ib}$ est une vitesse angulaire réelle du gyroscope, $b_{\omega r}$ est une dérive nulle du gyroscope, et $b_{\omega g}$ est un bruit blanc sorti par le gyroscope ;
   éliminer une interférence de champ magnétique par le modèle d'ellipse d'étalonnage de la boussole électronique ; dans lequel le modèle d'ellipse d'étalonnage de la boussole électronique est:

$$\frac{(mx - Xoffset)^2}{Xsf^2} + \frac{(my - Yoffset)^2}{Ysf^2} = 1 \quad,$$

   dans lequel *mx, my* sont des intensités de champ magnétique, *Xoffset* et *Yoffset* sont des interférences magnétiques dures, et *Xsf* et *Ysf* sont des interférences magnétiques douces ;
   mettre à jour l'attitude du véhicule par le modèle de filtrage EKF à sept dimensions, dans lequel, le modèle de filtrage EKF à sept dimensions utilise un filtre de Kalman étendu pour un vecteur d'état à sept dimensions, et EKF comprend une équation d'état et une équation d'observation :

$$x = f(x, \omega) + w1$$

$$y = h(x) + v1$$

dans lequel la matrice d'état est $x = [q\ b_{ar}]$, q est les vecteurs de quaternion $q_0$, $q_1$, $q_2$, $q_3$, et $b_{\omega r}$ est une dérive nulle du gyroscope à trois axes, dans lequel $\omega$ est la vitesse angulaire sortie par le gyroscope, $w1$ est une matrice de bruit de processus, $v1$ est une matrice de bruit d'observation, $y$ est un vecteur d'observation, $y = [a\ \psi_{mag}]^T$, dans lequel a est une valeur d'accélération à trois axes, $\psi_{mag}$ est un angle de course calculé par la boussole electronique,

$$f(x,\omega) = \begin{bmatrix} \dfrac{1}{2}\begin{bmatrix} -q_1 & -q_2 & -q_3 \\ q_0 & -q_3 & q_2 \\ q_3 & q_0 & -q_1 \\ -q_2 & q_1 & q_0 \end{bmatrix}\begin{bmatrix} \omega_x - b_{\omega x} \\ \omega_y - b_{\omega y} \\ \omega_z - b_{\omega z} \end{bmatrix} \\ 0^{3\times 1} \end{bmatrix}$$

$$h = \begin{bmatrix} 2g(q_1 q_3 - q_0 q_2) \\ 2g(q_2 q_3 + q_0 q_1) \\ g(q_0^2 - q_1^2 - q_2^2 + q_3^2) \\ \tan^{-1}\left(\dfrac{2(q_1 q_2 + q_0 q_3)}{q_0^2 + q_1^2 - q_2^2 - q_3^2}\right) \end{bmatrix}$$

2. Procédé de mise à jour d'un angle toutes-attitudes d'une machine agricole basé sur un capteur MEMS à neuf axes selon la revendication 1, **caractérisé en ce que** l'étape (S2) d'acquérir des données incluant une accélération et une vitesse angulaire d'un mouvement de véhicule, et une intensité de champ géomagnétique en temps réel par un capteur MEMS à neuf axes est décrite en détail ci-dessous :

   obtenir la vitesse angulaire du véhicule à travers le gyroscope, et compenser la dérive nulle du gyroscope ;
   acquérir l'accélération du véhicule par un capteur d'accélération; et
   acquérir l'intensité du champ géomagnétique du véhicule par le capteur géomagnétique.

3. Procédé de mise à jour d'un angle toutes-attitudes d'une machine agricole basé sur un capteur MEMS à neuf axes selon la revendication 2, **caractérisé en ce que** l'étape (S3) de calculer un angle, une vitesse, des informations sur la position et un angle de course du véhicule en utilisant le modèle d'erreur établi du gyroscope et le modèle d'ellipse d'étalonnage du compas électronique, en fonction des données obtenues incluant l'accélération et la vitesse angulaire du mouvement du véhicule, et l'intensité du champ géomagnétique est décrite en détail ci-dessous :

   obtenir l'angle par un calcul intégral de la vitesse angulaire par le modèle d'erreur du gyroscope ;
   calculer la vitesse en intégrant l'accélération, et les informations sur la position sont calculées en intégrant davantage la vitesse; et
   calculer l'angle de course du véhicule à partir de l'intensité du champ géomagnétique qui est compensée par un paramètre d'étalonnage et corrigée par un angle oblique, et le paramètre d'étalonnage et l'angle oblique étant tous deux calculés par le modèle elliptique.

4. Procédé de mise à jour d'un angle toutes-attitudes d'une machine agricole basé sur un capteur MEMS à neuf axes selon la revendication 3, **caractérisé en ce que** l'étape (S4) de traiter par fusion de données l'angle, la vitesse, les informations de position et l'angle de course du véhicule au moyen du modèle de filtrage EKF à sept dimensions, et mettre à jour l'angle d'attitude cinétique du véhicule en temps réel est décrite en détail ci-dessous :

   calculer l'angle d'attitude cinétique du véhicule par le modèle de filtrage EKF à sept dimensions, grâce à un algorithme de mise à jour de l'attitude du quaternion, dans lequel un processus de calcul de l'algorithme EKF est comme ci-dessous :

$$x_k(-) = \Phi_{k-1} x_k(+)$$

$$\Phi_k = e^{\frac{\partial f}{\partial x}}$$

$$P_k(-) = \Phi_{k-1} P_{k-1}(+) \Phi_{k-1}^T + Q$$

$$x_k(+) = x_k(-) + K_k \left[ y_k - h(x_k(-)) \right]$$

$$P_k(+) = [I - K_k H_k] P_k(-)$$

$$H_k = \frac{\partial h}{\partial x} \big|_k$$

$$K_k = P_k(-) H_k [H_k P_k(-) H_k^T + R_k]$$

dans lequel $k$ est un point temporel d'échantillonnage, $x_k$ est une estimation de l'état du système, (-) est un point temporel précédent, (+) est un point temporel ultérieur, $\phi_k$ est une matrice de transition d'état, $P_k$ est une matrice d'erreur quadratique moyenne minimale, Q est une matrice de covariance correspondant au vecteur d'état, $K_k$ est un gain d'erreur, $y_k$ est un vecteur d'observation, $H_k$ est une matrice de transition pour l'équation d'observation, $R_k$ est une matrice de covariance correspondant au vecteur d'observation ;

$$Q = \frac{q_0 + q_1 i + q_2 j + q_3 k}{\sqrt{q_0^2 + q_1^2 + q_2^2 + q_3^2}}$$

dans lequel Q est un vecteur quaternion, $q_0$, $q_1$, $q_2$, $q_3$ sont des scalaires formant le vecteur quaternion, i, j, k sont des vecteurs unitaires dans un système de coordonnées tridimensionnelles, une matrice d'attitude mise à jour est comme ci-dessous :

$$C_b^n = \begin{bmatrix} q_1^2 + q_0^2 - q_3^2 - q_2^2 & 2(q_1 q_2 - q_0 q_3) & 2(q_1 q_3 + q_0 q_2) \\ 2(q_1 q_2 + q_0 q_3) & q_2^2 - q_3^2 + q_0^2 - q_1^2 & 2(q_2 q_3 - q_0 q_1) \\ 2(q_1 q_3 + q_0 q_2) & 2(q_2 q_3 + q_0 q_1) & q_3^2 - q_2^2 - q_1^2 + q_0^2 \end{bmatrix}$$

dans lequel $C_b^n$ est une matrice de rotation pour transformer un système de coordonnées de porteuse en un système de coordonnées de navigation,

$$C_b^n = \begin{pmatrix} C_{11} & C_{12} & C_{13} \\ C_{21} & C_{22} & C_{23} \\ C_{31} & C_{32} & C_{33} \end{pmatrix} = \begin{pmatrix} \cos\gamma\cos\psi+\sin\gamma\sin\psi\sin\theta & \sin\psi\cos\theta & \sin\gamma\cos\psi-\cos\gamma\sin\psi\sin\theta \\ -\cos\gamma\sin\psi+\sin\gamma\cos\psi\sin\theta & \cos\psi\cos\theta & -\sin\gamma\sin\psi-\cos\gamma\cos\psi\sin\theta \\ -\sin\gamma\cos\theta & \sin\theta & \cos\gamma\cos\theta \end{pmatrix}$$

dans lequel $\gamma$, $\theta$, $\psi$ sont respectivement un angle de roulis, un angle de pas et l'angle de course.

5. Procédé de mise à jour d'un angle toutes-attitudes d'une machine agricole basé sur un capteur MEMS à neuf axes selon la revendication 4, **caractérisé en ce que** après l'étape (S4) de traiter par fusion de données l'angle, la vitesse, les informations de position et l'angle de course du véhicule au moyen du modèle de filtrage EKF à sept dimensions, et mettre à jour l'angle d'attitude cinétique du véhicule en temps réel, l'étape suivante est effectuée :
extraire l'angle toutes-attitudes du véhicule à partir de l'angle d'attitude cinétique du véhicule mis à jour, afin de déterminer une valeur de l'angle toutes-attitudes, l'angle toutes-attitudes du véhicule incluant l'angle de pas, l'angle de roulis et l'angle de course (S5), dans lequel

$$\begin{cases} \psi_{\text{Principle}} = \arctan\left(-\dfrac{C_{12}}{C_{22}}\right) \\ \theta_{\text{Principle}} = \arcsin C_{32} \\ \gamma_{\text{Principle}} = \arctan\left(-\dfrac{C_{31}}{C_{33}}\right) \end{cases}$$

l'angle de course est :

$$\psi = \begin{cases} \psi_{\text{principle}} \\ \psi_{\text{principle}}+360° & \text{Quand } C_{22} > 0 \begin{cases} \psi_{\text{principle}} > 0 \\ \psi_{\text{principle}} < 0 \end{cases} \\ \psi_{\text{principle}}+180° & \text{Quand } C_{22} < 0 \end{cases}$$

l'angle de pas est :

$$\theta = \theta_{\text{principle}}$$

l'angle de roulis est :

$$\gamma = \begin{cases} \gamma_{\text{principle}}+180° \\ \gamma_{\text{principle}}-180° & \text{Quand } C_{33} > 0 \begin{cases} \gamma_{\text{principle}} > 0 \\ \gamma_{\text{principle}} < 0 \end{cases} \\ \gamma_{\text{principle}} & \text{Quand } C_{33} < 0 \end{cases}$$

Establishing an error model of a gyroscope, an electronic compass calibration ellipse model and a seven-dimensional EKF filtering model, and setting a parameter vector corresponding to a vehicle motional attitude. — S1

Acquiring data including an acceleration and an angular velocity of a motion of vehicle, and a geomagnetic field. — S2

Calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity. — S3

Data-fusion processing the angle, the velocity, the position information and the course angle of the vehicle by the seven-dimensional EKF filtering model, and updating a motional attitude angle of the vehicle in real time. — S4

Fig. 1

Establishing an error model of a gyroscope, an electronic compass calibration ellipse model and a seven-dimensional EKF filtering model, and setting a parameter vector corresponding to a vehicle motional attitude. — S1

Acquiring data including an acceleration and an angular velocity of a motion of vehicle, and a geomagnetic field. — S2

Calculating an angle, a velocity, position information, and a course angle of the vehicle by established error model of the gyroscope and the electronic compass calibration ellipse model, according to obtained data including the acceleration and the angular velocity of the motion of vehicle, and the geomagnetic field intensity. — S3

Data-fusion processing the angle, the velocity, the position information and the course angle of the vehicle by the seven-dimensional EKF filtering model, and updating a motional attitude angle of the vehicle in real time. — S4

Extracting the all-attitude angle data of the vehicle from updated attitude data of the vehicle, to determine a value of attitude angle data, the all-attitude angle of the vehicle including the pitch angle, the rolling angle and the course angle. — S5

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LV ; YINXIN.** RESEARCH ON INTEGRATED ATTITUDE DETERMINATION SYSTEM BASED ON MEMS/GPS FOR MICROUAV. *CHINA MASTER'S THESES FULL-TEXT DATABASE,* 15 February 2015, 11-13, 26, , 27, , 35, , 37, , 38, , 44, , 59, , 66